Europäisches Patentamt

**European Patent Office**

**Office européen des brevets**

(19)

(11) Veröffentlichungsnummer : **0 160 187**
**B1**

(12) **EUROPÄISCHE PATENTSCHRIFT**

(45) Veröffentlichungstag der Patentschrift :
23.12.87

(51) Int. Cl.⁴ : **G 01 R 21/133**

(21) Anmeldenummer : **85102800.1**

(22) Anmeldetag : **12.03.85**

(54) **Verfahren zur Verarbeitung analoger Ausgangssignale von Strom- und Spannungswandlern sowie Einrichtung zur Durchführung des Verfahrens.**

(30) Priorität : 26.03.84 CH 1507/84

(43) Veröffentlichungstag der Anmeldung :
06.11.85 Patentblatt 85/45

(45) Bekanntmachung des Hinweises auf die Patenterteilung : 23.12.87 Patentblatt 87/52

(84) Benannte Vertragsstaaten :
CH DE FR LI SE

(56) Entgegenhaltungen :
EP-A- 0 063 402
DE-A- 3 015 234
REGELUNGSTECHNISCHE PRAXIS, Band 20, Nr. 6,
1978, Seiten 177-183; Al. SOCEANU: "Überwachung
und Steuerung des elektrischen Energieverbrauchs
mittels Prozessrechner"
PATENTS ABSTRACTS OF JAPAN, Band 7, Nr. 105 (P-
195)[1250], 7. Mai 1983, Seite 109P195

(73) Patentinhaber : BBC Brown Boveri AG
CH-5401 Baden (CH)

(72) Erfinder : Maschek, Martin
Juchstrasse 10
CH-8116 Würenlos (CH)
Erfinder : Mastner, Georg, Dr.
Loonstrasse 5
CH-5443 Niederrohrdorf (CH)

## Beschreibung

Die Erfindung bezieht sich auf ein Verfahren zur Verarbeitung analoger Ausgangssignale dezentraler Strom- und Spannungswandler in einer zentralen Auswerteeinrichtung gemäss dem Oberbegriff des Anspruchs 1 sowie auf eine Einrichtung zur Durchführung des Verfahrens.

Es ist ein Verfahren gemäss dem Oberbegriff des Anspruchs 1 bekannt (Electric Current Transducer for EHV Circuits ; Electric Power Research Institute, U.S.A. 1980), bei welchem die von einem einzigen Stromwandler in digital kodierter Form an eine Auswerteeinrichtung übertragenen Daten unmittelbar in ein analoges Signal zurückverwandelt werden. Ein solcher Stand der Technik ist desgleichen aus der EP-A-0 063 402 bekannt.

Es ist weiter ein Verfahren bekannt (Optical Fiber Communication System, Publikation GP-10566 der Meidensha Electric Mfg. Co. Ltd., Tokyo), bei welchem eine Synchronisierung gemeinsam weiterzuverarbeitender Daten durch von der zentralen Auswerteeinrichtung an die dezentralen Wandler übertragene Abtastbefehle erreicht wird. Eine solche Synchronisierung ist aufwendig und teuer und kompliziert die Anlage beträchtlich.

Aufgabe der Erfindung ist es, ein gattungsgemässes Verfahren anzugeben, bei welchem die von mehreren dezentralen Wandlern in digital kodierter Form an eine zentrale Auswerteeinrichtung übertragenen Daten derart aufbereitet werden, dass eine gemeinsame digitale Weiterverarbeitung derselben in der zentralen Auswerteeinrichtung, bei welcher die Phasenverschiebung zwischen gemeinsam weiterzuverarbeitenden Daten, d. h. der zeitliche Abstand zwischen den Abtastzeitpunkten, auf die von verschiedenen Wandlern stammende gemeinsam weiterzuverarbeitende digitalisierte Abtastwerte zurückgehen, einen z. B. durch Normen vorgegebenen Maximalwert nicht überschreiten soll, ermöglicht wird.

Ausserdem soll eine Einrichtung zur Durchführung des erfindungsgemässen Verfahrens angegeben werden.

Diese Aufgabe wird durch die Erfindung, wie sie in den Ansprüchen gekennzeichnet ist, gelöst.

Die durch die Erfindung erreichten Vorteile sind vor allem darin zu sehen, dass die analogen Ausgangssignale mehrerer Wandler derart aufbereitet werden können, dass eine gemeinsame digitale Weiterverarbeitung, bei welcher die relative Phasenverschiebung der in digitaler Kodierung vorliegenden Signale einen vorgegebenen Wert nicht überschreiten darf, möglich ist. Beispielsweise kann so die über eine Leitung übertragene Leistung, welche sich aus einer multiplikativen Verknüpfung von gleichzeitigen Spannungs- und Stromwerten ergibt und bei deren Berechnung nur geringe relative Phasenfehler zulässig sind, auf einfache Weise ermittelt werden.

Da keine zentrale Steuerung oder Synchronisierung dezentraler Einheiten erforderlich ist und die Uebertragung von Daten jeweils nur in einer Richtung, nämlich vom dezentral gelegenen Wandler zur zentralen Auswerteeinrichtung, zu erfolgen braucht, ist die zur Durchführung des erfindungsgemässen Verfahrens erforderliche Einrichtung verhältnismässig einfach und kostengünstig realisierbar. Sie kann ohne weiteres so ausgelegt werden, dass sie leicht an gegebene Verhältnisse und Anforderungen anpassbar und insbesondere ohne Schwierigkeiten erweiterbar ist.

Im folgenden wird die Erfindung anhand von lediglich einen Ausführungsweg darstellenden Zeichnungen näher erläutert.

Es zeigen

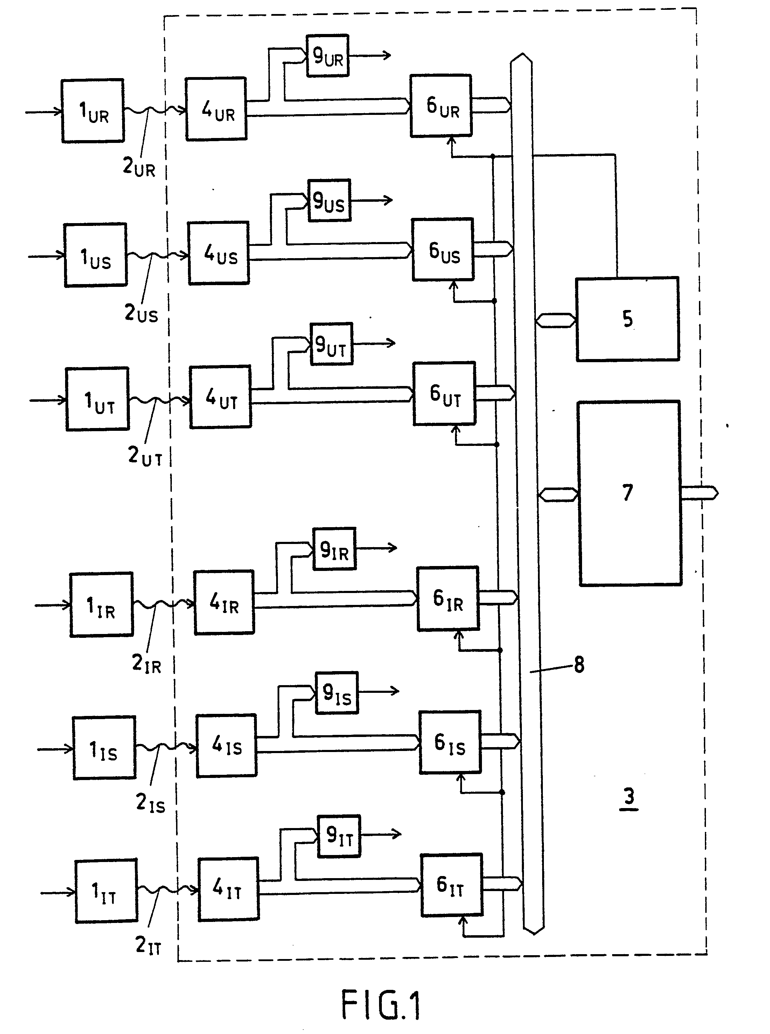

Fig. 1 in schematischer Darstellung eine erfindungsgemässe Einrichtung zur Durchführung des erfindungsgemässen Verfahrens und

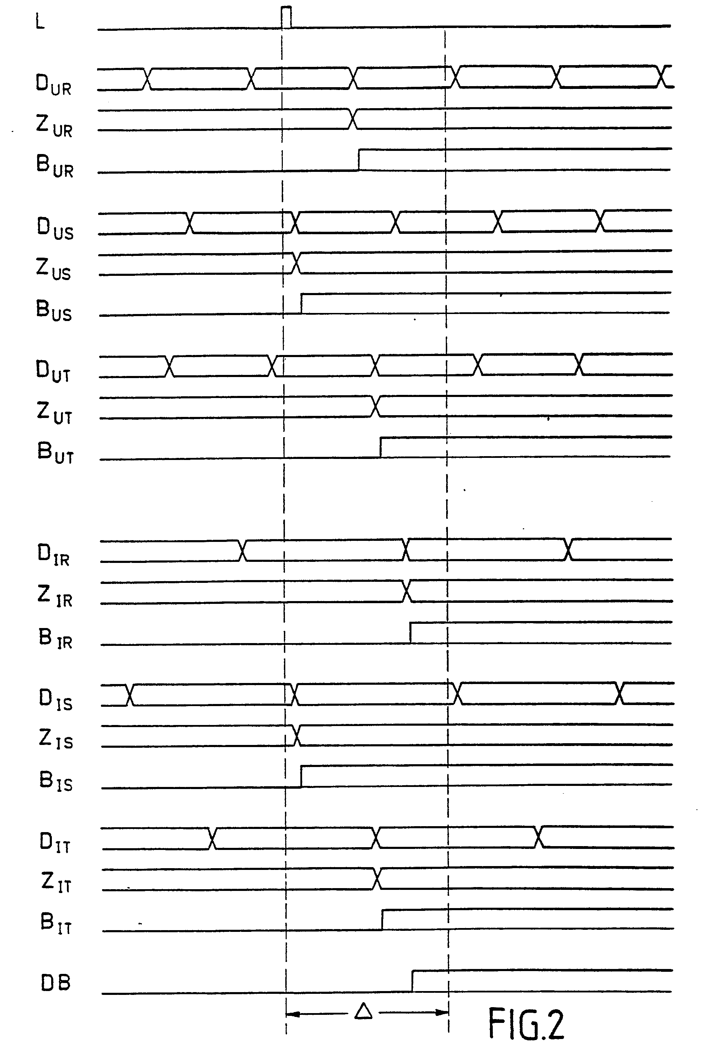

Fig. 2 beispielsweise Signalverläufe und Datenströme in der Einrichtung gemäss Fig. 1.

In den Figuren ist ein Verfahren veranschaulicht, bei welchem grundsätzlich das analoge Ausgangssignal eines dezentralen Strom- oder Spannungswandlers einem ebenfalls dezentralen Umsetzer-Sender $1_{UR}$, $1_{US}$, $1_{UT}$, $1_{IR}$, $1_{IS}$, $1_{IT}$ zugeführt und dort mittels eines schnellen A/D-Wandlers gemäss einem Taktraster, das von einem im Umsetzer-Sender $1_{UR}$, ... enthaltenen Taktgeber erzeugt wird, abgetastet und unmittelbar in einen seriellen Datenstrom $D_{UR}$, $D_{US}$, $D_{UT}$, $D_{IR}$, $D_{IS}$, $D_{IT}$ umgewandelt wird, der aus aufeinanderfolgenden digitalisierten Abtastwerten besteht. Der Datenstrom $D_{UR}$, ... gelangt, in Lichtimpulse umgewandelt, über eine mit einer Lichtleitfaser realisierte unidirektionale Datenleitung $2_{UR}$, ... an eine zentrale Auswerteeinrichtung 3, wo er in einem Empfänger-Umsetzer $4_{UR}$, ... in elektrische Signale und anschliessend in parallele digitale Daten umgewandelt wird.

Erfindungsgemäss wird in der zentralen Auswerteeinrichtung 3 in Abständen, welche von inneren und äusseren Parametern abhängen, jedoch nicht kleiner sind als das Maximum $\Delta$ der Taktintervalle der in den Umsetzer-Sendern $1_{UR}$, ... erzeugten Taktraster, von einer Steuereinheit 5 ein latch-Befehl L erzeugt, welcher bewirkt, dass der jeweils als nächster in der zentralen Auswerteeinrichtung 3 eintreffende digitalisierte Abtastwert jedes der Datenströme $D_{UR}$, ..., in einem Zwischenspeicher $6_{UR}$, ... zwischengespeichert wird. Die in den Zwischenspeichern $6_{UR}$, ... gespeicherten Daten $Z_{UR}$, ... bestehen daher zu jedem Zeitpunkt aus digitalisierten Abtastwerten, die zu Zeitpunkten, welche um weniger als das Maximum $\Delta$ der Taktintervalle der in den dezentralen Kodiereinheiten $1_{UR}$, ... erzeugten Taktraster auseinanderliegen, in der zentralen Auswerteeinrichtung eingetroffen sind, d. h., abgesehen von eventuellen Laufzeitunterschieden, die aber im allgemeinen nicht ins Gewicht fallen bzw. kompensiert werden können, auf Abtastungen zurückgehen, die um weniger als besagtes Maximum $\Delta$ der Taktintervalle auseinanderliegen. Unmittelbar nach dem Einspeichern eines neuen digitalisierten Abtastwerts in einen der Zwischenspeicher $6_{UR}$, ... wird jeweils ein « Bereit »-Signal $B_{UR}$, ... erzeugt. Die « Bereit »-Signale $B_{UR}$, ... werden, einzeln oder zu einem « Datensatz bereit »-Signal UND-verknüpft, einem Rechner 7 zugeführt. Sobald das « Datensatz bereit »-Signal DB gesetzt ist, kann der Rechner 7 die in den Zwischenspeichern $6_{UR}$, ... gespeicherten digitalen Abtastwerte der Reihe nach über einen Datenbus 8 abfragen. Auf diese Weise ist ein besonders rascher Zugriff auf besagte Abtastwerte möglich.

Parallel zu den Zwischenspeichern $6_{UR}$, ... sind D/A-Wandler $9_{UR}$, ... an die von den Empfänger-Umsetzern $4_{UR}$, ... ausgehenden Datenleitungen angeschlossen, welche die digitalen Daten in den analogen Ausgangssignalen der Wandler entsprechende Analogsignale zurückverwandeln und welchen ältere analoge Geräte nachgeschaltet sein können.

Bei dem dargestellten Beispiel stammen die analogen Ausgangssignale von drei Spannungswandlern und drei Stromwandlern, welche eine dreiphasige Leitung überwachen. Die Abtastraten liegen z. B. bei 1 Mal in 5 μsec für die Stromwandler und bei etwas weniger als 1 Mal in 3 μsec für die Spannungswandler. Das führt auf eine obere Grenze für die zeitliche Differenz zwischen Abtastungen, auf welche gemeinsam weiterzuverarbeitende Dateneinheiten zurückgehen, von 5 μsec, was auch strengsten Anforderungen genügt. Die angegebenen Abtastraten sind mit handelsüblichen Komponenten, z. B. dem 12-bit A/D-Wandler AD 578 der Firma Analog Devices, erreichbar. Für viele Zwecke genügen jedoch wesentlich niedrigere Werte.

**Patentansprüche**

1. Verfahren zur Verarbeitung analoger Ausgangssignale dezentraler Strom- und Spannungswandler in einer zentralen Auswerteeinrichtung (3), bei welchem das analoge Ausgangssignal jedes Wandlers jeweils entsprechend einem dezentral erzeugten Taktraster abgetastet und unmittelbar in Form eines Datenstroms ($D_{UR}$, ...) aus aufeinanderfolgenden digitalisierten Abtastwerten an die zentrale Auswerteeinrichtung (3) übermittelt wird, dadurch gekennzeichnet, dass in der zentralen Auswerteeinrichtung (3) Datensätze, welche je einen digitalisierten Abtastwert aus jedem Datenstrom ($D_{UR}$, ...) enthalten, erstellt werden, indem in Abständen, welche nicht kleiner als das Maximum (Δ) der Taktintervalle der dezentral erzeugten Taktraster sind, latch-Befehle (L) erzeugt werden und nach jedem latch-Befehl (L) der jeweils eben anliegende oder der jeweils als nächster eintreffende digitalisierte Abtastwert eines jeden Datenstroms ($D_{UR}$, ...) erfasst wird.

2. Verfahren nach Anspruch 1, dadurch gekennzeichnet, dass das Maximum (Δ) der Taktintervalle der dezentral erzeugten Taktraster nicht mehr als 200 μsec und vorzugsweise höchstens 5 μsec beträgt.

3. Verfahren nach Anspruch 1 oder 2, dadurch gekennzeichnet, dass jeweils nach der Erfassung eines digitalisierten Abtastwerts aus einem Datenstrom ($D_{UR}$, ...) nach einem latch-Befehl (L) ein « Bereit »-Signal ($B_{UR}$, ...) gesetzt wird und durch UND-Verknüpfung dieser Signale ein « Datensatz bereit »-Signal (DB) erzeugt wird, sobald ein Datensatz erstellt ist.

4. Einrichtung zur Durchführung des Verfahrens nach einem der Ansprüche 1 bis 3, mit dezentralen Umsetzer-Sendern ($1_{UR}$, ...), welche über potentialtrennende Datenleitungen ($2_{UR}$, ...) mit der zentralen Auswerteeinrichtung (3) verbunden sind, dadurch gekennzeichnet, dass die zentrale Auswerteeinrichtung (3) einen Rechner (7) enthält sowie an die Dantenleitungen ($2_{UR}$, ...) angeschlossene Zwischenspeicher ($6_{UR}$, ...) und eine Steuereinheit (5), welche dieselben steuert und insbesondere die latch-Befehle (L) erzeugt.

5. Einrichtung nach Anspruch 4, dadurch gekennzeichnet, dass die zentrale Auswerteeinrichtung (3) einen Datenbus (8) enthält, an den sowohl der Rechner (7) als auch die Zwischenspeicher ($6_{UR}$, ...) angeschlossen sind.

6. Einrichtung nach Anspruch 4 oder 5, dadurch gekennzeichnet, dass sie mindestens einen parallel zu einem der Zwischenspeicher ($6_{UR}$, ...) angeschlossenen D/A-Wandler ($9_{UR}$, ...) enthält.

**Claims**

1. Method for processing analog output signals of decentralized current and voltage transformers in a centralized evaluating device (3) in which the analog output signal of each transformer is in each case sampled in accordance with a clock spacing generated at a decentralized location and is directly transmitted in the form of a data stream ($D_{UR}$, ...) of successive digitized samples to the centralized evaluating device (3), characterized in that in the centralized evaluating device (3) data records, which each contain one digitized sample from each data stream ($D_{UR}$, ...), are generated by generating latch commands (L) at intervals which are not shorter than the maximum (Δ) of the clock intervals of the clock spacing generated at a decentralized location and, after each latch command (L), the digitized sample, which happens to be present in each case or which in each case arrives as the next one, of each data stream ($D_{UR}$, ...) is acquired.

2. Method according to Claim 1, characterized in that the maximum (Δ) of the clock intervals of the clock spacing generated at a decentralized location is no longer than 200 μsec and preferably 5 μsec at the most.

3. Method according to Claim 1 or 2, characterized in that in each case after acquisition of a digitized sample from a data stream ($D_{UR}$, ...) after a latch command (L), a « ready » signal ($B_{UR}$, ...) is set and a « data record ready » signal (DB) is generated by ANDing these signals as soon as a data record is generated.

4. Device for carrying out the method according to one of Claims 1 to 3, comprising decentralized converter/transmitters ($I_{UR}$, ...) which are connected via potentialisolating data lines ($2_{UR}$, ...) to the centralized evaluating device (3), characterized in that the centralized evaluating device (3) contains a computer (7) and buffer stores ($6_{UR}$, ...) connected to the data lines ($2_{UR}$, ...) and a control unit (5) which controls the buffer stores and, in particular, generates the latch commands (L).

5. Device according to Claim 4, characterized in that the centralized evaluating device (3) contains a data bus (8) to which both the computer (7) and the buffer stores ($6_{UR}$, ...) are connected.

6. Device according to Claim 4 or 5, characterized in that it contains at least one D/A converter ($9_{UR}$, ...) which is connected in parallel with one of the buffer stores ($6_{UR}$, ...).

**Revendications**

1. Procédé pour traiter des signaux de sortie analogiques de transformateurs de courant et de tension décentralisés dans un dispositif d'évaluation central (3), suivant lequel le signal de sortie analogique de chaque transformateur est échantillonné chaque fois selon un rythme produit de manière décentralisée et est immédiatement transmis au dispositif d'évaluation central (3) sous forme d'un flux de données ($D_{UR}$, ...) constitué de valeurs d'échantillonnage digitalisées successives, caractérisé en ce que dans le dispositif d'évaluation central (3) sont produits des articles de données qui contiennent chacun une valeur d'échantillonnage digitalisée provenant de chaque flux de données ($D_{UR}$, ...), par le fait que, par intervalles qui ne sont pas inférieurs à l'intervalle maximum ($\Delta$) entre impulsions au rythme produit de manière décentralisée, des ordres de verrouillage (L) sont produits et qu'après chaque ordre de verrouillage (L), est prise pour chaque flux de données ($D_{UR}$, ...), la valeur d'échantillonnage digitalisée qui est précisément présente ou qui est la prochaine à arriver.

2. Procédé suivant la revendication 1, caractérisé en ce que l'intervalle maximum ($\Delta$) entre impulsions au rythme produit de manière décentralisée, n'atteint pas plus de 200 microsecondes et est de préférence de 5 microsecondes au maximum.

3. Procédé suivant la revendication 1 ou 2, caractérisé en ce qu'après chaque prise d'une valeur d'échantillonnage digitalisée dans un flux de données ($D_{UR}$, ...), après un ordre de verrouillage (L), un signal « prêt » ($B_{UR}$, ...) est positionné et que, par une intersection logique de ces signaux, un signal « article de données prêt » (DB) est produit dès qu'un article de données a été préparé.

4. Dispositif pour l'exécution du procédé suivant l'une quelconque des revendications 1 à 3, comportant des convertisseurs-émetteurs ($I_{UR}$, ...) qui sont connectés au dispositif d'évaluation central (3) par l'intermédiaire de lignes de données à coupure de potentiel ($2_{UR}$, ...), caractérisé en ce que le dispositif d'évaluation central (3) contient un calculateur (7), de même que des mémoires intermédiaires ($6_{UR}$, ...) connectées aux lignes de données ($2_{UR}$, ...) et une unité de commande (5) qui commande ces mémoires et, en particulier, produit les ordres de verrouillage (L).

5. Dispositif suivant la revendication 4, caractérisé en ce que le dispositif d'évaluation central (3) contient un but de données (8) auquel sont connectés tant le calculateur (7) que les mémoires intermédiaires ($6_{UR}$, ...).

6. Dispositif suivant la revendication 4 ou 5, caractérisé en ce qu'il contient au moins un convertisseur numérique-analogique ($9_{UR}$, ...) qui est connecté en parallèle à l'une des mémoires intermédiaires ($6_{UR}$, ...).

FIG.1

FIG.2